Europäisches Patentamt

European Patent Office

Office européen des brevets

(11) Veröffentlichungsnummer: **0 201 061 B1**

(12) **EUROPÄISCHE PATENTSCHRIFT**

(45) Veröffentlichungstag der Patentschrift: **15.01.92**

(21) Anmeldenummer: **86106047.3**

(22) Anmeldetag: **02.05.86**

(51) Int. Cl.⁵: **H04L 27/06**, G04G 7/02

(54) **Empfänger für amplitudengetastete Zeitzeichensignale.**

(30) Priorität: **10.05.85 DE 3516810**

(43) Veröffentlichungstag der Anmeldung:
**12.11.86 Patentblatt 86/46**

(45) Bekanntmachung des Hinweises auf die
Patenterteilung:
**15.01.92 Patentblatt 92/03**

(84) Benannte Vertragsstaaten:
**FR GB IT NL SE**

(56) Entgegenhaltungen:
**DE-A- 2 802 040**
**DE-A- 3 101 406**

(73) Patentinhaber: **TELEFUNKEN electronic GmbH
Theresienstrasse 2
W-7100 Heilbronn(DE)**

(72) Erfinder: **Allgaier, Jürgen
Unterdorf 35
W-7233 Lauterbach(DE)**
Erfinder: **Böhme, Rolf, Dr.
Sudetenstrasse 1
W-7107 Bad Friedrichshall(DE)**
Erfinder: **Ganter, Wolfgang
Heiligenbronnerstrasse 52
W-7230 Schramberg(DE)**
Erfinder: **Rinderle, Heinz
Goerdelerstrasse 82
W-7100 Heilbronn(DE)**

(74) Vertreter: **Maute, Hans-Jürgen, Dipl.-Ing.
Licentia Patent-Verwaltungs-GmbH Theodor-
Stern-Kai 1
W-6000 Frankfurt/Main 70(DE)**

## Beschreibung

Die Erfindung betrifft eine integrierbare Empfängerschaltung für den Empfang eines amplitudengetasteten Zeitzeichensignales, welches zur Steuerung oder Synchronisation von Uhren dient, die eine sehr genaue Zeit liefern. Ein solches Zeitzeichensignal wird beispielsweise vom Sender DCF 77 der Deutschen Bundespost in Mainflingen gesendet.

Bei einem Zeitzeichensignal wird beispielsweise die Amplitude eines langwelligen Trägers im Sekundentakt auf etwa 25 % der vollen Amplitude getastet. Durch die Dauer der Tastung, für die beim Sender DEF 17 die Werte 0,1 s oder 0,2 s vorgesehen sind, kann im Verlaufe einer Minute ein sogenanntes Zeittelegramm übertragen werden, das in binär verschlüsselter Form die Information zu Zeit und Datum enthält.

Der Empfänger eines Zeitzeichensignales hat die Aufgabe, die Amplitudentastung des Hochfrequenzsignales als Impulsfolge zu dekodieren. Die nachfolgende Aufgabe, aus der gewonnenen Impulsfolge durch logische Signalverarbeitung Steuersignale für eine Zeitanzeige o. dgl. aufzubereiten, wird von der vorliegenden Erfindung nicht berührt.

Wegen der geringen Informationsmenge genügt ein schmalbandiger Übertragungskanal von typisch 10 bis 50 Hz Bandbreite. Derartige Empfänger wurden für wissenschaftliche und technische Zwecke in mehreren Varianten entwickelt. Eine eingehende Diskussion der damit verbundenen Probleme enthält die Arbeit von R. Bermbach und M. Lobjinski "Neue Funkuhren aus dem Institut für Datentechnik in Funkuhren", 4. Darmstädter Kollogium, von W. Hilberg, München, Wien, Oldenburg, 1983. In dieser Veröffentlichung wird auf den Hauptnachteil des Geradeausempfängers, die Gefahr der Selbsterregung, insbesondere bei enger Nachbarschaft zur Antenne und auf den Hauptnachteil des Überlagerungsempfängers, dem komplizierten Abgleich, hingewiesen.

Aus DE A - 2 802 040 ist ein Empfänger für Zeitzeichensignale bekannt, wobei die Zeitzeichensignale mit Hilfe einer aktiven Ferritantenne aufgefangen, unmittelbar an der Antenne verstärkt und über ein Koaxialkabel zum Hochfrequenzdemodulator geleitet werden. Dort wird das Signal zunächst durch ein sehr schmalbandiges Quarzfilter ausgefiltert, durch einen geregelten Verstärker verstärkt, gleichgerichtet und einem Komparator zugeführt. Der Komparator erzeugt aus dem Signal Rechteckimpulse, die einem Mikrocomputer zur weiteren Auswertung zugeführt werden. Auch bei dieser Anordnung ist die Antenne räumlich getrennt vom Empfänger angeordnet, um die Gefahr der Selbsterregung zu reduzieren.

Die Aufgabe der vorliegenden Erfindung besteht darin, einen Empfänger für amplitudengetastete Zeitzeichensignale anzugeben, der einen möglichst geringen Einrichtungsaufwand erfordert, der eine enge Nachbarschaft zur Antenne erlaubt, der in einem weiten Feldstärkebereich funktionsfähig ist und dar mit kleinstem Raum- und Energiebedarf auskommt.

Diese Aufgabe wird bei einem Empfänger für amplitudengetastete Zeitzeichensignale erfindungsgemäß dadurch gelöst, daß ein abgestimmter Antennenkreis, ein Regelverstärker, ein Filter, ein Nachverstärker und ein Gleichrichter vorgesehen und in der genannten Reihenfolge miteinander verbunden sind, daß die dem Regelverstärker zugeführte Regelspannung aus der Differenz des Signales des Gleichrichters und des Signales einer Referenzquelle gebildet und durch einen Speicherkondensator gemittelt wird, und daß eine Dekodiereinheit vorgesehen ist, die aus der Regelspannung die Hüllkurve der Amplitudentastung ermittelt.

Die Erfindung wird nachstehend anhand der Zeichnung beschrieben. Es zeigen

Fig. 1:     ein Blockschaltbild der Empfängeranordnung,

Fig. 2:     charakteristische Abhängigkeiten vom Eingangssignal,

Fig. 3:     das Prinzip der Antennenumschaltung,

Fig. 4:     Einzelheiten zu Filter, Nachverstärker und Gleichrichter,

Fig. 5:     eine verbesserte Ausführungsform des Filters,

Fig. 6:     eine einfache Dekodiereinrichtung,

Fig. 7:     eine allgemeinere Dekodiereinrichtung.

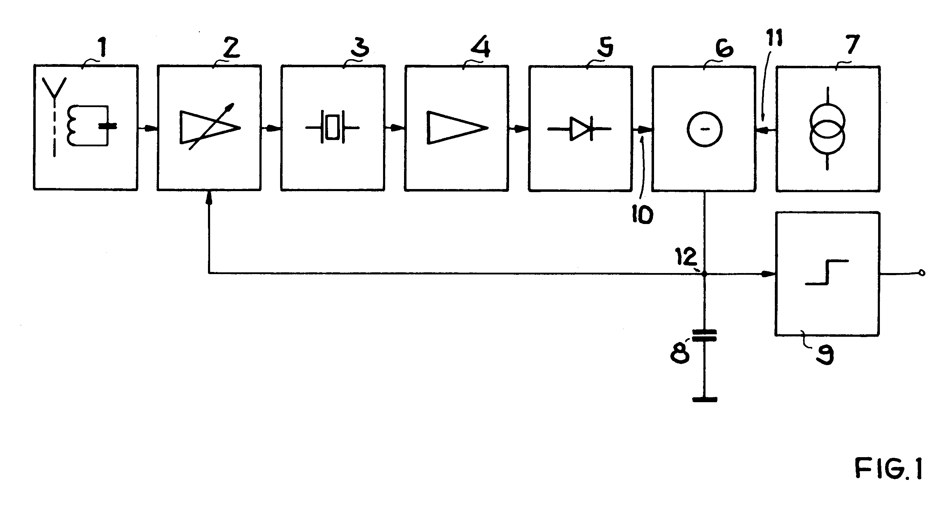

Das in Fig. 1 dargestellte Blockschaltbild der Empfängeranordnung stellt einen Geradeausempfänger dar. Die Antenne 1 ist als Rahmen- oder Ferritantenne ausgeführt und auf den Zeitzeichensender abgestimmt. Die Antenne ist mit dem Eingang eines Regelverstärkers 2 verbunden. Ein zweiter Eingang des Regelverstärkers 2 dient der Zuführung der Steuerspannung 12. Die Verstärkung des Regelverstärkers 2 hängt exponentiell von der Regelspannung 12 ab, wobei gewisse Abweichungen von der Exponentialfunktion je nach Gestaltung der übrigen Funktionseinheiten zulässig sind. Über ein vorzugsweise piezoelektrisches Filter 3, das ebenfalls auf die Frequenz des Zeitzeichensenders abgestimmt ist, ist der Ausgang des Regelverstärkers 2 mit dem Eingang eines Nachverstärkers 4 verbunden. Dem Nachverstärker 4 schließt sich ein Gleichrichter 5 an. In einer Subtrahiereinheit 6 wird das gleichgerichtete HF-Signal 10 vom Signal 11 einer Referenzquelle 7 subtrahiert und auf einen Speicherkondensator 8 geleitet. Die Spannung des Speicherkondensators 8 bildet die Regelspannung 12 des Regelverstärkers 2.

Speicherkondensator 8 und die Subtrahiereinheit 6 bilden einen Differenzintegrator, der die Differenz aus Gleichrichtersignal 10 und Referenzsignal 11 über der Zeit integriert. Stimmt der Mittelwert des Gleichrichtersignales nicht mit dem Referenzsignal überein, so ändert sich die Regelspannung 12 über dem Speicherkondensator. Dadurch verändert sich die Verstärkung des Regelverstärkers 2 in dem Sinne, daß die angenommene Differenz vermindert wird. Der Vorgang kommt dann zur Ruhe, wenn mittleres Gleichrichtersignal 10 und Referenzsignal 11 übereinstimmen.

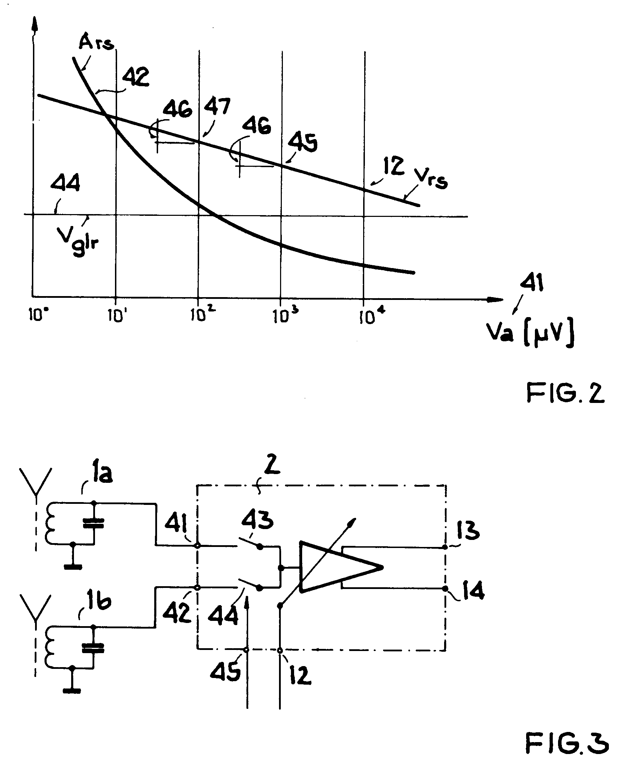

Das mittlere Gleichrichtersignal ist unabhängig von der Amplitude des Antennensignales und die Verstärung des Regelverstärkers umgekehrt proportional zur Amplitude des Antennensignales. Ist nun, wie vorgesehen, die Kennlinie des Regelverstärkers exponentiell, so wird die Spannung 12 des Speicherkondensators 8 eine logarithmische Abhängigkeit von der Amplitude des Antennensignales haben. Diese Verläufe sind in Fig. 2 dargestellt, wo mittleres Gleichrichtersignal Vglr 44, Verstärkung des Regelverstärkers Ars 42, und Regelspannung Vrs 12 über der logarithmisch aufgetragenen Antennenspannung Va/$\mu$V 41 dargestellt ist. Eine Veränderung der Amplitude des Antennensignales um einen bestimmten Faktor, z.B. um den Faktor 0,25, wie er bei der Amplitudentastung angewandt wird, verändert die Regelspannung um einen bestimmten Betrag. Dieser Betrag ist unabhängig vom Ausgangswert der empfangenen Antennenspannung. So hat die Tastung vom Ausgangswert 45 die gleiche Änderung 46 der Regelspannung 12 zur Folge wie die Tastung vom Ausgangswert 47. Es genügt also, daß die Antennenspannung in den Regelbereich des Empfängers fällt, um eine feststehende Änderung der Regelspannung zu erhalten. Das dynamische Verhalten der Regelschleife wird durch Wahl des Speicherkondensators 8 und der Bandbreite des Filters 3 der Dauer der Tastung angepaßt. Das Zeitzeichensignal wird aus der Regelspannung dekodiert. Während man bei der üblichen Dekodierung aus dem Gleichrichtersignal die Regelschleife so träge machen muß, daß die Regelspannung dem Tastsignal nicht folgen kann, kann man beim vorgeschlagenem Verfahren wesentlich kleinere Zeitkonstanten anwenden. Damit ergibt sich ein kleinerer Speicherkondensator, eine kleinere Einlaufzeit nach dem Einschalten und eine kürzere Übersteuerungserholzeit.

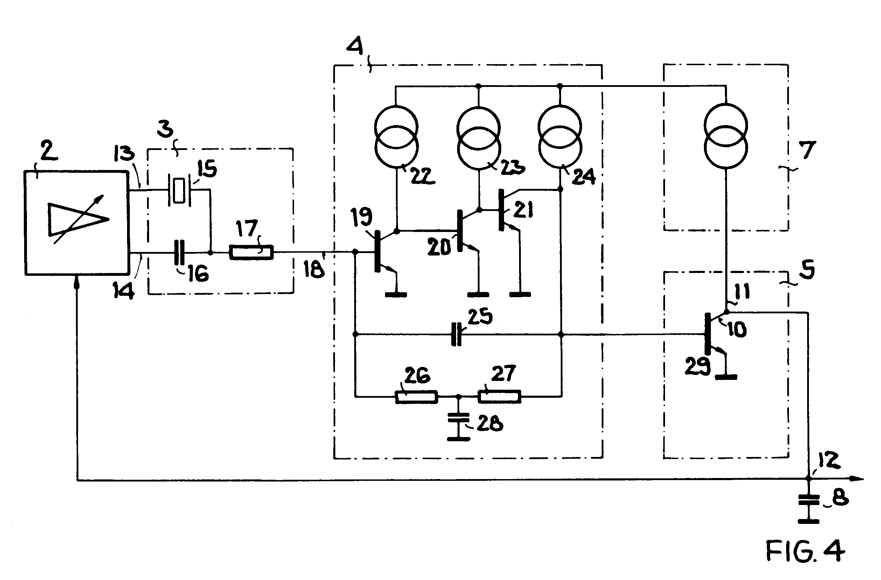

Die Verwendung einer Ferrit- oder Rahmenantenne hat den Nachteil, daß in Abhängigkeit von der Empfangsrichtung ein ausgeprägtes Minimum der Empfangsspannung existiert. Um aufwendige Einrichtungen für eine Drehung der Antenne zu vermeiden, werden z.B. zwei um 90° versetzte Antennen verwendet und über ein Laufzeitglied miteinander verbunden. Mit dem Einsatz integrierter Schaltungen ist es aber wirtschaftlicher, gemäß Fig. 3 im Empfänger mehrere Eingänge 41, 42 vorzusehen, die mit verschiedenen Antennen 1a, 1b verbunden sind. Die Eingänge werden über Umschalter 43, 44 zum Verstärkereingang durchgeschaltet. Die Umschaltung wird durch eine Einrichtung mit dem Steuereingang 45 bewirkt. Diese Einrichtung kann z.B. so gestaltet sein, daß bei Anlegen des logischen Pegels 0 am Steuereingang 45 der Eingang 41 über den Schalter 43 aktiviert ist, oder daß bei Anlegen des logischen Pegels 1 am Steuereingang 45 der Eingang 42 über den Schalter 44 aktiviert ist. Das Steuersignal für die Antennenumschaltung kann in einer dem Empfänger nachgeschalteten logischen Signalverarbeitung gewonnen werden.

Nach dem Regelverstärker 2 ist eine weitere Selektion durch ein piezoelektrisches Filter 3 vorgesehen. Dazu zeigt Fig. 4 eine bevorzugte Ausführungsform mit einem piezoelektrischen Resonator 15, der z.B. aus einem Quarz-Schwinger besteht, einer Kompensationskapazität 16 und einem Widerstand 17. Es ist dabei vorgesehen, daß der Regelverstärker 2 zwei Ausgänge 13, 14 aufweist, die zueinander im Gegentakt liegende Signale führen. Resonator 15 und Kompensationskapazität 16 sind mit den Ausgängen 13 und 14 verbunden. Der Widerstand 17 führt zum Eingang 18 des Nachverstärkers 4. Die drei genannten Schaltelemente sind zu einer Sternschaltung verbunden.

Durch die Verwendung des piezoelektrischen Filters kann die niedrige Bandbreite von 10 bis 50 Hz des Geradeausempfängers leicht erreicht werden. Ausgenutzt wird die Serienresonanz des Resonators 15. Die Kompensationskapazität 16 kompensiert in Verbindung mit dem Gegentaktausgang 14 des Regelverstärkers 2 die übliche Parallel-Kapazität des Resonators 15 und verbessert damit die Weitab-Selektion. Der Widerstand 17 erhöht den Serienwiderstand des Resonators und gestattet die Einstellung der Bandbreite auf den Sollwert. Dabei ist vorgesehen, daß der Eingangswiderstand des Nachverstärkers klein gegenüber der Quellimpedanz am Eingang ist.

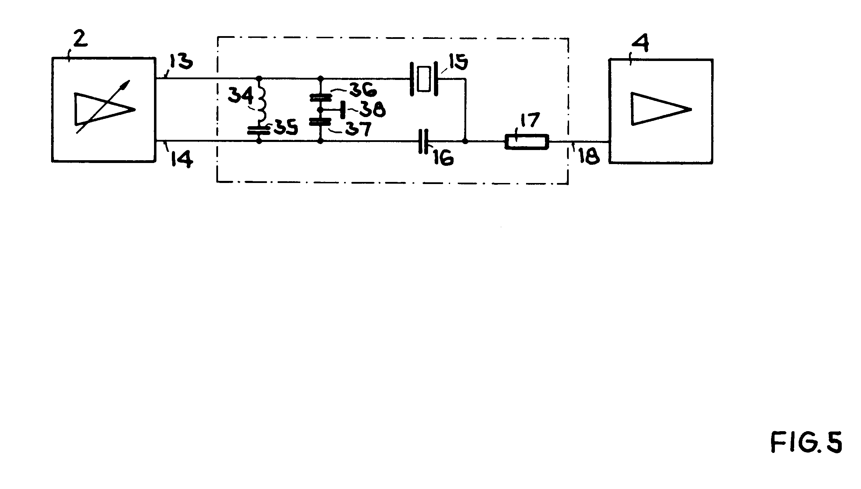

Bei höheren Anforderungen an die Selektivität, insbesondere der Weitab-Selektion, können auch noch LC-Glieder hinzugefügt werden. Dazu zeigt Fig. 5 ein Beispiel, das sich auf innenwiderstandsbehaftete Regelverstärkerausgänge 13, 14 bezieht. Eine Reihenschaltung einer Induktivität 34 mit einem Kondensator 35, die an die Regelverstärkerausgänge angeschlossen ist, besitzt eine Serienresonanz unterhalb der Empfangsfrequenz und gestattet die Unterdrückung eines störenden Senders. Zwei weitere Kondensatoren 36, 37, die zueinander in Reihe und zum Serienresonanzkreis parallel geschaltet sind, bilden mit ersterem eine Parallelresonanz bei der Empfangsfrequenz und belasten dann den Regelverstärker 2 minimal. Eine Erdung 38 des Verbindungspunktes der beiden Kondensatoren 36, 37 verbessert die Symmetrie der Aussteuerung und dient damit der ausreichenden Weitab-Selektion.

Ein Nachverstärker 4 nach dem Filter 3 hat die Aufgabe, den Signalpegel auf den für eine Gleichrichtung ausreichenden Wert zu bringen. Am Ausgang des Regelverstärkers 2 wird ein verhältnismäßig niedriger Signalpegel zu wählen sein, um eine ausreichende Aussteuerungsreserve für Fremdsignale auf benachbarten Frequenzen zu haben. Entsprechend niedrig ist der Signalpegel am Eingang 18 des Nachverstärkers 4. Fig. 4 zeigt, wie diese Aufgabe vorteilhaft gelöst werden kann. Ein direkt gekoppelter, invertierender Verstärker, der beispielsweise aus drei Transistoren 19, 20, 21 und drei Stromquellen 22, 23, 24 besteht, ist über ein RC-Netzwerk gegengekoppelt. Das RC-Netzwerk kann die Form eines überbrückten T-Gliedes haben mit zwei Längswiderständen 26, 27, einer Querkapazität 28 und einer Überbrückungskapazität 25. Es kann aber auch bei höheren Anforderungen ein sogenanntes Doppel-T-Glied eingesetzt werden. Ein solcherart beschalteter Verstärker weist eine Bandpasscharakteristik mit einer schwachen, für den vorliegenden Zweck unwesentlichen Tiefpass-Komponente auf. Er unterstützt somit die Weitab-Selektion des Empfängers.

Die in Fig. 4 gezeigte schaltungstechnische Gestaltung erlaubt insbesondere die Verwendung niedriger Versorgungsspannungen und -ströme durch eine vorteilhafte Gleichspannungskopplung mit dem Gleichrichter 5, der als Transistor 29 in Emitterschaltung ausgeführt ist. Dabei wird davon ausgegangen, daß der Eingangtransistor 19 des Nachverstärkers 4 ebenfalls in Emitterschaltung betrieben wird, und daß über die Widerstände 26, 27 des überbrückten T-Gliedes kein wesentlicher Gleichspannungsabfall auftritt. Unter diesen Voraussetzungen unterscheidet sich die Basis-Emitter-Spannung des am Ausgang des Nachverstärkers 4 angeschlossenen Gleichricht-Transistors 29 nur unwesentlich von der Basis-Emitter-Spannung des Eingangtransistors 19. Geht man weiter davon aus, daß Gleichricht-Transistor 29 und Eingangstransistor 19 einer gemeinsamen, integrierten Schaltung angehören und gleiche Parameter haben, so werden sich die Ruheströme der beiden Transistoren ebenfalls nur geringfügig unterscheiden. Der Strom des Eingangtransistors 19 wird im Beispiel durch die kollektorseitige Stromquelle 22 festgelegt. Bei üblicher Dimensionierung wird es ein verhältnismäßig kleiner Strom sein. Das bedeutet, daß der Ruhe-Arbeitsstrom des Gleichricht-Transistors 29 eben diesen, kleinen Strom aufweist. Erfolgt nunmehr um diesen Ruhearbeitspunkt eine Aussteuerung, so tritt bereits bei Amplituden um etwa 10 mV eine deutliche Erhöhung des mittleren Stromes durch den Gleichricht-Transistor ein. Somit kann schon mit einer Wechselspannung von z.B. 10 mV ein brauchbarer Gleichricht-Effekt erzielt werden. Durch diese verhältnismässig niedrige Hochfrequenzspannung bleibt die Gesamtverstärkung niedrig und die Gefahr von Rückkopplungen zum Eingang ist gering. Damit ist auch eine wichtige Voraussetzung erfüllt, die Antenne in unmittelbarer Nachbarschaft zum Empfänger anzuordnen.

Nach Fig. 4 ist der Kollektor des Gleichricht-Transistors 29 mit der Referenzquelle 7, die hier als Stromquelle ausgeführt ist, sowie mit dem Speicherkondensator 8 verbunden. Außerdem ist am Speicherkondensator 8 der Regelspannungseingang des Regelverstärkers 2 angeschlossen. Wie bereits beschrieben, bildet diese Anordnung die Differenz des Richtstromes 10 mit dem Referenzstrom 11, lädt damit den Speicherkondensator 8, und die davon gebildete Regelspannung 12 steuert den Regelverstärker in Richtung der Gleichheit von mittlerem Richtstrom und Referenzstrom. Bei einer praktischen Ausführung sind auch Vorwiderstände an den Elektroden des Gleichricht-Transistors 29 vorgesehen. Ein Vorwiderstand an der Basis vermindert die nichtlineare Belastung des Nachverstärkers durch den Eingangswiderstand des Gleichricht-Transistors. Ein Vorwiderstand am Emitter schert die exponentielle Steuerkennlinie des Gleichricht-Transistors 29 und linearisiert den Stromverlauf bei großer Aussteuerung. Ein Vorwiderstand am Kollektor begrenzt den Strom des Gleichricht-Transistors und damit die Abfallgeschwindigkeit der Regelspannung bei den positiven Amplitudensprüngen des Zeitzeichen-Signals.

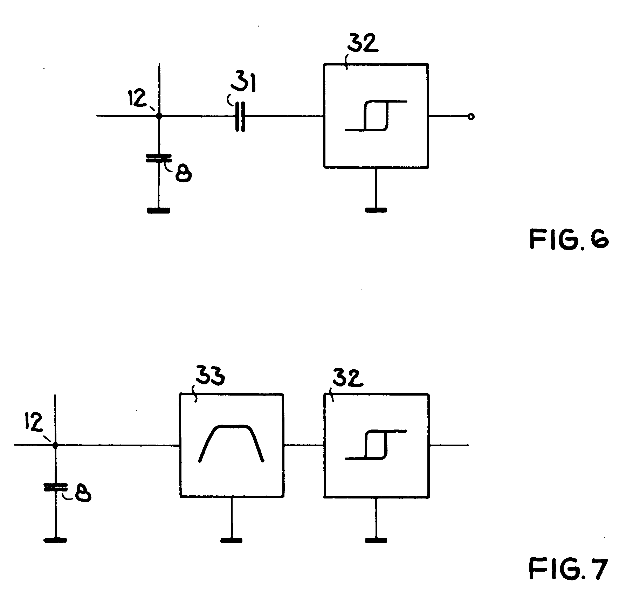

Bei entsprechender Wahl des Speicherkondensators 8 und der Parameter der abgestimmten Antenne 1 und des Filters 3 wird der Amplitudengang des Zeitzeichensignales näherungsweise in die Regelspannung abgebildet. Die logarithmische Abhängigkeit der Regelspannung von der Amplitude des HF-Signales führt dazu, daß die Änderungen der Regelspannung 12 unabhängig von der Stärke des empfangenen Signales ablaufen. Deshalb ist nach Fig. 6 vorgesehen, daß die Dekodierung aus der Regelspannung 12 mit einem Schmitt-Trigger erfolgt, der über einen Koppelkondensator 31 am Speicherkondensator 8 angeschlossen ist. Dabei ist vorausgesetzt, daß der Schmitt-Trigger einen niederohmigen Eingangswiderstand aufweist. Die vom Zeitzeichensignal verursachten, raschen Änderungen der Regelspannung 12 ziehen eine entsprechende Umladung des Koppelkondensators 31 nach sich. Der dem Eingang des Schmitt-Triggers zufließende Ladestrom kippt den Schmitt-Trigger in den zugeordneten Schaltzustand. Die Empfindlichkeit der Anordnung wird man so wählen, daß die Tastungen des Zeitzeichensignales die Umschaltung des Schmitt-Triggers mit Sicherheit auslösen, während kleinere, durch Störungen verursachte Schwankungen der Regelspannung ohne Wirkung bleiben.

Da die Einfügung des Koppelkondensators 31 die wirksame Kapazität vergrößert, muß der Speicherkondensator 8 entsprechend verkleinert werden. Unter Umständen kann der Speicherkondensator 8 zu Gunsten des Koppelkondensators 31 weggelassen werden.

Der Koppelkondensator 31 hat für den Schmitt-Trigger die Funktion eines Differenziergliedes. Dies hat den Nachteil, daß die Dekodierung empfindlich gegenüber steilen Impulsflanken ist. Zur Optimierung der Störfestigkeit des Systems ist deshalb gemäss der Fig. 7 zwischen Speicherkondensator und Schmitt-Trigger 32 ein Filter 33 eingefügt. Eine Ausführung des Filters 33 aus Widerständen und Kondensatoren, mit der Charakteristik eines breiten Bandpasses, gestattet eine bessere Störunterdrückung als das erstgenannte Differenzierglied.

**Patentansprüche**

1. Empfänger für amplitudengetastete Zeitzeichensignale mit einem abgestimmten Antennenkreis (1), einem Regelverstärker (2), einem Filter (3), einem Nachverstärker (4) und einem Gleichrichter (5), die in der genannten Reihenfolge miteinander verbunden sind, dadurch gekennzeichnet, daß die dem Regelverstärker zugeführte Regelspannung (12) aus der Differenz des Signales (10) des Gleichrichters (5) und des Signales (11) einer Referenzquelle (7) gebildet und durch einen Speicherkondensator (8) gemittelt wird und daß eine Dekodiereinheit (9) vorgesehen ist, die aus der Regelspannung (12) die Hüllkurve der Amplitudentastung ermittelt.

2. Empfänger nach Anspruch 1, dadurch gekennzeichnet, daß der abgestimmte Antennenkreis (1) aus einer Ferrit-Antenne oder einer Rahmen-Antenne besteht.

3. Empfänger nach Anspruch 1 oder 2, dadurch gekennzeichnet, daß das Filter (3) ein piezoelektrisches Filter ist.

4. Empfänger nach einem der Ansprüche 1 bis 3, dadurch gekennzeichnet, daß mehrere abgestimmte Antennenkreise vorgesehen und mit mehreren Eingängen des Regelverstärkers (2) verbunden sind.

5. Empfänger nach einem der Ansprüche 1 bis 4, dadurch gekennzeichnet, daß der Regelverstärker (2) Einrichtungen zur Umschaltung der Eingänge aufweist.

6. Empfänger nach einem der Ansprüche 1 bis 5, dadurch gekennzeichnet, daß die Verstärkung des Regelverstärkers (2) zumindest näherungsweise exponentiell von der Regelspannung (12) abhängt.

7. Empfänger nach einem der Ansprüche 1 bis 6, dadurch gekennzeichnet, daß der Regelverstärker zwei Ausgänge (13, 14) aufweist, die zueinander im Gegentakt arbeiten.

8. Empfänger nach einem der Ansprüche 1 bis 7, dadurch gekennzeichnet, daß das Filter (3) aus einem Quarzresonator oder keramischen Resonator (15), einer Kompensationskapazität (16) und einem Widerstand (17) besteht, daß der Quarzresonator oder keramische Resonator (15) mit dem ersten Ausgang (13) des Regelverstärkers (2), die Kompensationskapazität (16) mit dem zweiten Ausgang (14) des Regelverstärkers (2) und der Widerstand (17) mit dem Eingang (18) des Nachverstärkers (4) verbunden sind und daß die übrigen Anschlüsse der drei genannten Schaltelemente miteinander verbunden sind.

9. Empfänger nach einem der Ansprüche 1 bis 8, dadurch gekennzeichnet, daß eine RC-Schaltung als Gegenkopplung für den Nachverstärker vorgesehen ist.

10. Empfänger nach einem der Ansprüche 1 bis 9, dadurch gekennzeichnet, daß die RC-Schaltung ein überbrücktes T-Glied ist, in dessen Längszweigen Widerstände (26, 27), in dessen Querzweig eine Querkapazität (28) und in dessen Überbrückungszweig eine Überbrückungskapazität (25) angeordnet ist.

11. Empfänger nach einem der Ansprüche 1 bis 10, dadurch gekennzeichnet, daß die Eingangsstufe des Nachverstärkers aus einem Transistor (19) in Emitterschaltung und der Gleichrichter (5) aus einem Transistor (29) in Emitterschaltung besteht.

12. Empfänger nach einem der Ansprüche 1 bis 11, dadurch gekennzeichnet, daß der Basis und/oder dem Emitter und/oder dem Kollektor des Transistors (29) des Gleichrichters ein Vorwiderstand vorgeschaltet ist.

13. Empfänger nach einem der Ansprüche 1 bis 12, dadurch gekennzeichnet, daß die Referenzquelle (7) als Stromquelle ausgeführt ist, die mit dem Kollektor des Transistors (29) des Gleichrichters, dem Speicherkondensator (8) und dem Steuereingang des Regelverstärkers (2) verbunden ist.

14. Empfänger nach einem der Ansprüche 1 bis 13, dadurch gekennzeichnet, daß der Speicherkondensator (8) eine solche Kapazität aufweist, daß der Verlauf der Kondensatorspannung im wesentlichen der Amplitudentastung des Zeitzeichensignales entspricht.

15. Empfänger nach einem der Ansprüche 1 bis 14, dadurch gekennzeichnet, daß die Dekodiereinrichtung aus einem Schmitt-Trigger (32) besteht, der über einen Koppelkondensator (31) am Speicherkondensator (8) angeschlossen ist.

16. Empfänger nach einem der Ansprüche 1 bis 15, dadurch gekennzeichnet, daß der Schmitt-Trigger (32) einen niederohmigen Eingangswiderstand aufweist und daß die Funktion des Speicherkondensators (8) ganz oder teilweise der Koppelkondensator (31) übernimmt.

17. Empfänger nach einem der Ansprüche 1 bis 16, dadurch gekennzeichnet, daß zwischen den Speicherkondensator (8) und den Schmitt-Trigger (32) ein Filter (33) geschaltet ist.

18. Empfänger nach einem der Ansprüche 1 bis 17, dadurch gekennzeichnet, daß das Filter (33) aus Widerständen und Kondensatoren besteht und eine Bandpass-Charakteristik aufweist.

**Claims**

1. Receiver for amplitude-scanned time-signal signals with a tuned aerial circuit (1), an AGC amplifier (2), a filter (3), a post-amplifier (4) and a rectifier (5), which are connected with one another in the above-mentioned sequence, characterised in that the control voltage (12) fed to the AGC amplifier is formed from the difference of the signal (10) of the rectifier (5) and the signal (11) of a reference source (7) and is averaged by a storage capacitor (8), and that a decoder unit (9) is provided which determines from the control voltage (12) the envelope curve of the amplitude scanning.

2. Receiver according to claim 1, characterised in that the tuned aerial circuit (1) consists of a ferrite aerial or a frame aerial.

3. Receiver according to claim 1 or 2, characterised in that the filter (3) is a piezoelectric filter.

4. Receiver according to any one of claims 1 to 3, characterised in that a plurality of tuned aerial circuits are provided and are connected to a plurality of inputs of the amplifier (2).

5. Receiver according to any one of claims 1 to 4, characterised in that the amplifier (2) contains devices for changing over the inputs.

6. Receiver according to any one of claims 1 to 5, characterised in that the amplification of the amplifier (2) depends at least approximately exponentially on the control voltage (12).

7. Receiver according to any one of claims 1 to 6, characterised in that the AGC amplifier comprises two outputs (13, 14) which operate in push-pull to one another.

8. Receiver according to any one of claims 1 to 7, characterised in that the filter (3) consists of a quartz resonator or ceramic resonator (15), a compensation capacitor (16) and a resistor (17), that the quartz resonator or ceramic resonator (15) is connected to the first output (13) of the amplifier (2), the compensation capacitor (16) to the second output (14) of the amplifier (2) and the resistor (17) to the input (18) of the post-amplifier (4), and that the remaining terminals of the three above-mentioned circuit elements are connected to one another.

9. Receiver according to any one of claims 1 to 8, characterised in that an RC circuit is provided as negative feedback for the post-amplifier.

10. Receiver according to any one of claims 1 to 9, characterised in that the RC circuit is a bridged-T network in whose longitudinal members resistors (26, 27) are disposed, in whose cross member a shunt capacitor (28) is disposed and in whose bridging member a bypass capacitor (25) is disposed.

11. Receiver according to any one of claims 1 to 10, characterised in that the input stage of the post-amplifier consists of a transistor (19) in grounded emitter configuration and the rectifier (5) consists of a transistor (29) in grounded emitter configuration.

12. Receiver according to any one of claims 1 to 11, characterised in that a series resistor is connected in series with the base and/or the emitter and/or the collector of the transistor (29) of the rectifier.

13. Receiver according to any one of claims 1 to 12, characterised in that the reference source (7) is constructed as a current source which is connected to the collector of the transistor (29) of the rectifier, to the storage capacitor (8) and to the control input of the amplifier (2).

14. Receiver according to any one of claims 1 to 13, characterised in that the storage capacitor (8) exhibits a capacitance such that the curve of the capacitor voltage corresponds substantially to the amplitude scanning of the time-signal signal.

15. Receiver according to any one of claims 1 to 14, characterised in that the decoding device consists of a Schmitt trigger (32) which is connected via a coupling capacitor (31) to the storage capacitor (8).

16. Receiver according to any one of claims 1 to 15, characterised in that the Schmitt trigger (32) comprises a low-valued input resistor and that the coupling capacitor (31) takes over completely or partially the function of the storage capacitor (8).

17. Receiver according to any one of claims 1 to 16, characterised in that between the storage capacitor (8) and the Schmitt trigger (32) a filter (33) is connected.

18. Receiver according to any one of claims 1 to 17, characterised in that the filter (33) consists of resistors and capacitors and exhibits a band-pass filter characteristic.

**Revendications**

1. Récepteur de signaux horaires modulés par sauts d'amplitude, comportant un circuit d'antenne accordé (1), un amplificateur réglable (2), un filtre (3), un post-amplificateur (4) et un redresseur (5) associés par branchement dans l'ordre indiqué, caractérisé par le fait que la tension de réglage (12) amenée à l'amplificateur réglable est formée à partir de la différence entre le signal (10) du redresseur (5) et le signal (11) d'une source de référence (7) et est l'objet d'une formation de moyenne par un condensateur accumulateur (8), et par le fait qu'il est prévu une unité de décodage (9) qui, à partir de la tension de réglage (12), élabore la courbe-enveloppe de la modulation par sauts d'amplitude.

2. Récepteur selon revendication 1, caractérisé par le fait que le circuit d'antenne accordé est constitué par une antenne avec ferrite ou par une antenne à cadre.

3. Récepteur selon revendication 1 ou 2, caractérisé par le fait que le filtre (3) est un filtre piézoélectrique.

4. Récepteur selon l'une des revendications 1 à 3, caractérisé par le fait qu'il est prévu plusieurs circuits d'antenne accordés qui sont reliés à plusieurs entrées de l'amplificateur réglable (2).

5. Récepteur selon l'une des revendications 1 à 4, caractérisé par le fait que l'amplificateur réglable (2) présente des dispositifs pour la commutation des entrées.

6. Récepteur selon l'une des revendications 1 à 5, caractérisé par le fait que l'amplification de l'amplificateur réglable (2) dépend, au moins approximativement de manière exponentielle, de la tension de réglage (12).

7. Récepteur selon l'une des revendications 1 à 6, caractérisé par le fait que l'amplificateur réglable (2) présente deux sorties (13, 14) qui opèrent selon des alternances opposées.

8. Récepteur selon l'une des revendications 1 à 7, caractérisé par le fait que le filtre (3) est constitué par un résonateur à quartz ou par un résonateur céramique (15), par une capacité de compensation (16) et par une résistance (17), par le fait que le résonateur à quartz ou le résonateur céramique (15) est relié à la première sortie (13) de l'amplificateur réglable (2), la capacité de compensation (16) est reliée à la deuxième entrée (14) de l'amplificateur réglable (2), et la résistance (17) est reliée à l'entrée (18) du post-amplificateur (4), et par le fait que les autres bornes des trois éléments précités sont reliées les unes aux autres.

9. Récepteur selon l'une des revendications 1 à 8, caractérisé par le fait qu'il est prévu un circuit RC en tant que couplage de contreréaction pour le post-amplificateur.

10. Récepteur selon l'une des revendications 1 à 9, caractérisé par le fait que le circuit RC est un circuit en T shunté, dont les bras horizontaux comportent des résistances (26, 27) et dont la hampe verticale comporte une capacité (28), les moyens de shuntage comportant une capacité de pontage (25).

11. Récepteur selon l'une des revendications 1 à 10, caractérisé par le fait que l'étage d'entrée du post-amplificateur est constitué par un transistor (19) monté en émetteur commun et le redresseur est constitué par un transistor (29) monté en émetteur commun.

12. Récepteur selon l'une des revendications 1 à 11, caractérisé par le fait que la base et/ou l'émetteur et/ou le collecteur du transistor (29) du redresseur est précédé par une résistance série.

13. Récepteur selon l'une des revendications 1 à 12, caractérisé par le fait que la source de référence (7) est réalisée en tant que source de courant qui est reliée au collecteur du transistor (29) du redresseur, au condensateur accumulateur (8) et à l'entrée de commande de réglage de l'amplificateur réglable (2).

14. Récepteur selon l'une des revendications 1 à 13, caractérisé par le fait que le condensateur accumulateur (8) présente une capacité telle que l'évolution de sa tension corresponde sensiblement à la modulation par sauts d'amplitude du signal horaire.

15. Récepteur selon l'une des revendications 1 à 14, caractérisé par le fait que le dispositif décodeur est constitué par un circuit de gâchette dit trigger de Schmitt (32) qui est raccordé au condensateur accumulateur (8) par l'intermédiaire d'un condensateur de couplage (31).

16. Récepteur selon l'une des revendications 1 à 15, caractérisé par le fait que le circuit de gâchette dit trigger de Schmitt (32) présente une faible résistance d'entrée et par le fait que la fonction du condensateur accumulateur (8) est assumée totalement ou partiellement par le condensateur de couplage 31.

17. Récepteur selon l'une des revendications 1 à 16, caractérisé par le fait qu'un filtre (33) est monté entre le condensateur accumulateur (8) et le circuit de gâchette dit trigger de schmitt (32).

18. Récepteur selon l'une des revendications 1 à 17, caractérisé par le fait que le filtre (33) est constitué par des résistances et condensateurs et présente une caractéristique de passe-bande.

FIG.1

FIG. 2

FIG.3

FIG. 4

EP 0 201 061 B1

FIG.5

FIG. 6

FIG. 7